# EUROPEAN PATENT APPLICATION

(11) **EP 4 761 488 A1**
(43) Date of publication of application: **17.06.2026**
(21) Application number: 25223801.9
(22) Date of filing: 16.12.2025
(51) Int. Cl.: H05K 7/20, G06F 1/20, H10W 40/47

(54) **LIQUID COOLING OF STACKED ARCHITECTURE ELECTRONIC MICROCHIPS**

(30) Priority: 16.12.2024 US 202463734486 P
(71) Applicant: Carrier Corporation, Palm Beach Gardens, FL 33418 (US)
(72) Inventor: JOARDAR, Arindom, Syracuse, NY 13057 (US); MCQUARY, Bryan, Syracuse, NY 13057 (US)
(74) Representative: Dehns

(57) **Abstract**

A cooling system (100) includes a heat removal device (102) operable to cool a stacked microchip assembly (64). The heat removal device (102) includes a structure (104) having a first end (106), a second end (108), at least one sidewall (110) extending between and connecting the first end (106) and the second end (108), and a hollow interior. The stacked microchip assembly (64) is positionable within the hollow interior. An inlet cavity (112) and an outlet cavity (114) are arranged within the hollow interior and are fluidly connectable to at least one passageway (66) formed in the stacked microchip assembly (64). An inlet opening (116) is formed in the structure (102) and is fluidly connected with the inlet cavity (112). An outlet opening (118) formed in the structure (102) is fluidly connected with the outlet cavity (114). A first cooling fluid (C1) is movable from the inlet cavity (112) to the outlet cavity (114) through the at least one passageway (66) formed in the stacked microchip assembly (64).

## Description

### BACKGROUND

Exemplary embodiments pertain to the art of thermal management, and more particularly, relate to thermal management of a server within a data center.

A "data center" refers to the physical location of one or more servers. A data center and the servers housed within a data center typically consume a significant amount of electrical power. Existing servers are designed to be cooled at least partially by a flow of air. Such servers usually include one or more printed circuit boards having a plurality of operable heat-generating devices mounted thereto. The printed circuit boards are commonly housed in an enclosure having vents configured to direct external air from the data center into, through and out of the enclosure. The air absorbs heat dissipated by the components and after being exhausting from the enclosure, mixes with the ambient air. An air conditioner is then used to cool the heated air of the data center and to recirculate it, repeating the cooling process.

Higher performance server components typically dissipate more power. However, the amount of heat that conventional cooling system can remove from a server is in part limited by the extent of the air conditioning available from the data center. In general, a lower air temperature in a data center allows each server component cooled by an air flow to dissipate a higher power, and thus allows each server to operate at a correspondingly higher level of performance.

### BRIEF DESCRIPTION

According to a first aspect of the invention, there is provided a cooling system includes a heat removal device operable to cool a stacked microchip assembly. The heat removal device includes a structure having a first end, a second end, at least one sidewall extending between and connecting the first end and the second end, and a hollow interior. The stacked microchip assembly is positionable within the hollow interior. An inlet cavity and an outlet cavity are arranged within the hollow interior and are fluidly connectable to at least one passageway formed in the stacked microchip assembly. An inlet opening is formed in the structure and is fluidly connected with the inlet cavity. An outlet opening formed in the structure is fluidly connected with the outlet cavity. A first cooling fluid is movable from the inlet cavity to the outlet cavity through the at least one passageway formed in the stacked microchip assembly.

Further embodiments may include that the structure is hermetically sealable about the stacked microchip assembly.

Further embodiments may include that the first cooling fluid is operable to passively circulate through the cooling system.

Further embodiments may include a pump fluidly connectable to at least one of the inlet cavity and the outlet cavity. The pump is operable to actively circulate the first cooling fluid through the cooling system.

Further embodiments may include at least one spray nozzle arranged within the inlet cavity. The at least one spray nozzle being oriented to spray the first cooling fluid into the at least one passageway formed in the stacked microchip assembly.

Further embodiments may include that the first end of the structure is positionable adjacent to a printed circuit board coupled to the stacked microchip assembly and at least one of the inlet opening and the outlet opening is formed in the second end of the structure.

Further embodiments may include that the first cooling fluid provided to the inlet cavity is a single phase.

Further embodiments may include that the first cooling fluid provided to the inlet cavity is a liquid.

Further embodiments may include a second heat removal device arranged in series with the heat removal device relative to a flow of the first cooling fluid.

Further embodiments may include that the second heat removal device is arranged downstream from the heat removal device relative to a flow of the first cooling fluid.

Further embodiments may include that the second heat removal device is a heat exchanger.

Further embodiments may include that the second heat removal device is thermally coupled to a surface of the heat removal device.

Further embodiments may include that the second heat removal device is thermally coupled to a surface of a second heat-generating device. The second heat-generating device being distinct from the first heat-generating device.

Further embodiments may include at least one fluid movement device for providing a second cooling fluid to the second heat removal device, the second cooling fluid being arranged in a heat transfer relationship with the first cooling fluid at the second heat removal device.

According to a second aspect of the invention, there is provided a method of cooling a stacked microchip assembly includes providing a heat removal device including a structure having a hollow interior within which the stacked microchip assembly is arranged and moving a first cooling fluid through one or more passageways formed in the stacked microchip assembly.

Further embodiments may include moving the first cooling fluid through the one or more passageways includes passively moving the first cooling fluid through the one or more passageways.

Further embodiments may include passively moving the first cooling fluid includes maintaining a pressure differential between an inlet cavity and an outlet cavity fluidly coupled to opposite ends of the one or more passageways.

Further embodiments may include moving the first cooling fluid through the one or more passageways includes pumping the first cooling fluid through the one or more passageways.

Further embodiments may include that the first cooling fluid provided to the one or more passageways formed in the stacked microchip assembly is a liquid.

Further embodiments may include arranging the first cooling fluid in a heat transfer relationship with a second cooling fluid at a second heat removal device, the second heat removal device being arranged in series with the heat removal device.

### BRIEF DESCRIPTION OF THE DRAWINGS

The following descriptions should not be considered limiting in any way. With reference to the accompanying drawings, like elements are numbered alike:
FIG. 1 is a front view of a data center rack having a plurality of servers mounted therein;
FIG. 2 is a perspective view of a server;
FIG. 3A is a top view of a server;
FIG. 3B is a cross-sectional side view of the server of FIG. 3A;
FIG. 4 is a perspective view of a heat removal device for cooling a stacked microchip assembly;
FIG. 5 is a schematic diagram of a heat removal device for cooling a stacked microchip assembly;
FIG. 6A is a perspective view of a heat removal device for cooling a stacked microchip assembly with the second end of the structure of the heat removal device removed;
FIG. 6B is a perspective view of the heat removal device of FIG. 6A with;
FIG. 7 is a schematic diagram of a second heat removal device;
FIG. 8 is a schematic diagram of a second heat removal device;
FIG. 9 is a cross-sectional view of a heat spreader having an integral fluid circuit;
FIG. 10 is a schematic diagram of a portion of a circuit of the first cooling fluid of the cooling system;
FIG. 11 is a schematic diagram of a circuit of the first cooling fluid of a cooling system; and
FIG. 12 is a schematic diagram of a circuit of the first cooling fluid of a cooling system; and
FIG. 13 is a schematic diagram of a circuit of the first cooling fluid of a cooling system.

### DETAILED DESCRIPTION

A detailed description of one or more embodiments of the disclosed apparatus and method are presented herein by way of exemplification and not limitation with reference to the Figures.

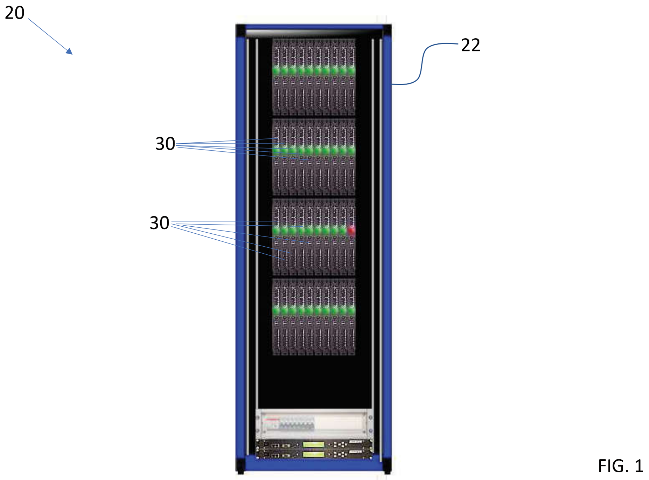

With reference now to FIG. 1, an example of a data center 20 is illustrated. As shown, the data center 20 includes a cabinet 22 having at least one, and in some embodiments, a plurality of slots (not shown) formed therein. One or more server rack sub-assemblies, also referred to herein as servers 30 may be permanently or removably mountable within the cabinet 22, such as within the one or more slots formed therein. The plurality of slots, and therefore the at least one server 30 receivable therein, may have a generally vertical orientation (shown), or alternatively, may have a horizontal orientation. In some embodiments, the data center 20 may include a combination of both horizontally oriented and vertically oriented slots. Further, although only a single cabinet 22 is illustrated in the FIG., it should be appreciated that the data center 20 may include several cabinets 22. In embodiments including a plurality of cabinets 22, the plurality of cabinets 22 may be arranged at the same location within a building, or alternatively, one or more of the cabinets 22 may be arranged at a different location within a single building or within multiple buildings.

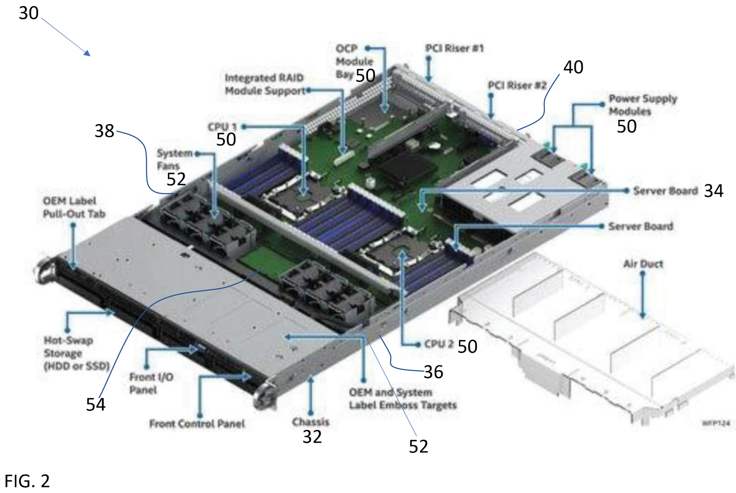

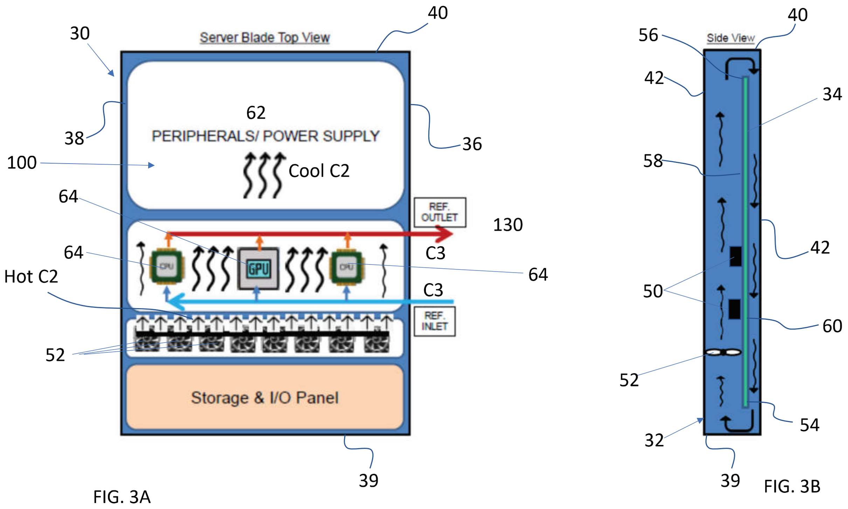

With reference now to FIGS. 2 and 3A, an example of a server 30 receivable within a slot of the cabinet 22 is illustrated. As shown, the server 30 may include a frame or chassis 32 having at least one printed circuit board 34 mounted to the frame. Although only a single printed circuit board 34 is illustrated in FIG. 2, it should be understood that in some embodiments, a plurality of printed circuit boards may be mounted to the chassis 32. The chassis 32 is designed to be insertable, for example slidably insertable, into a slot of a server rack and allow for connection to power cables, data cables, and/or other connecting cables provided at or by the cabinet 22.

The chassis 32 may include a plurality of walls 36, 38, 39, and 40 oriented at an angle to the printed circuit board 34 and that extend about all or at least a portion of a periphery of the printed circuit board 34. In an embodiment, the chassis 32 includes at least one flat, generally planar panel connected to one or more of the peripheral walls 36, 38, 40 of the chassis 32. The at least one flat panel 42 may be arranged at either a first side or a second side of the printed circuit board 34. When the server 30 is in a horizontal orientation as shown, such a flat panel 42 may be vertically offset from the printed circuit board 34, either above or underneath the printed circuit board. In some embodiments, best shown in FIG. 3B, a flat panel 42 may be arranged both above and below the printed circuit board. In an embodiment, the chassis 32 in combination with the flat panels 42 form a sealed, air-tight container surrounding the server 30. However, embodiments where a separate jacket or container is positioned about the server 30 to form an air-tight assembly are also contemplated herein. Additionally, embodiments involving air exchanges with ambient are also within the scope wherein ambient air is drawn into the server which extracts heat from the heat generating components and is then discharged out with or without thermal management.

At least one heat-generating electronic device 50 may be mounted or electrically connected to the printed circuit board 34. Examples of a heat-generating electronic device 50 include but are not limited to a processor such as a central processing unit and/or graphics processing unit, a memory, a hard drive, and a power supply module. A server 30 may also include one or more components that are not mounted to or are not electrically connected to the printed circuit board 34. In embodiments where the server 30 includes two or more of the same type of component, such as central processing units for example, the components may be aligned along an axis extending between the lateral sides 36, 38 of the chassis 32, may be aligned along an axis extending between the front and back of the chassis 32, or may be offset from one another in one or more directions. It should be appreciated that any heat-generating electronic device 50 may be located at any position within the chassis 32 or about the printed circuit board 34.

In an embodiment, one or more fluid movement devices 52 are mounted to the printed circuit board 34 and are operable to move a flow of a fluid, such as air over the heat-generating electronic devices 50. In the illustrated, non-limiting embodiment, the at least one fluid movement device is a fan 52 arranged near a first end 54 of the printed circuit board 34 such that when the server 30 is installed within the cabinet 22 the at least one fan 52 is positioned closer to the front of the cabinet 22 than the heat-generating electronic devices 50. However, embodiments where one or more fluid movement devices 52 are arranged at another suitable location, such as near a second end 56 of the printed circuit board 34 or of the chassis 32 associated with the rear of the cabinet 22 for example, are also within the scope of the disclosure. It should be appreciated that a server 30 having any suitable configuration, including servers having a full width or a half width or sled configuration are within the scope of the disclosure.

In an embodiment, the fluid moved by the at least one fluid movement devices 52 is configured to make a single pass over the heat-generating electronic devices 50. For example, cool air may be drawn into a fan 52 from a location adjacent to the front of the chassis 32 and after removing heat from the heat-generating electronic devices 50, may be exhausted at the back of the chassis 32. It should be appreciated that the air exhausted from the back of the cabinet 22 may be the same temperature as the surrounding environment, warmer than the surrounding environment, or even cooler than the surrounding environment. In other embodiments, such as where the chassis 32 includes at least one flat panel 42 for example, the fluid may be configured to continuously circulate within the server 30. For example, as best shown in FIG. 3B, a fluid movement device 52 may push the flow of fluid across the heat-generating electronic devices 50 arranged at a first surface 58 of the printed circuit board 34. Upon reaching the second end 56 of the printed circuit board 34, the fluid may turn through one or more openings and make a second pass along the second, opposite surface 60 of the printed circuit board 34. Upon reaching the first end 54 of the printed circuit board 34, the fluid may turn again, and be drawn back into an inlet of the at least one fluid movement device 52.

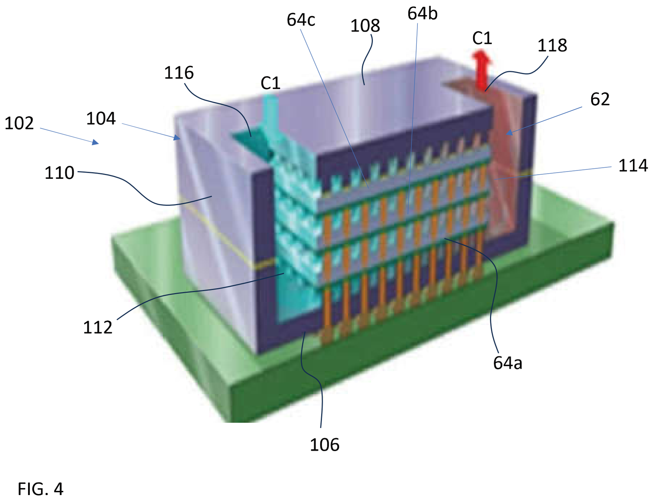

With reference now to FIGS. 4, 5, and 6A, in an embodiment, the one or more heat-generating electronic devices 50 of a server 30 includes a stacked microchip assembly, illustrated at 62. A stacked microchip assembly 62 includes a plurality of microchips (or other heat-generating electronic devices) 64 that are aligned with one another and stacked along an axis. In an embodiment, the plurality of microchips 64 within a stacked microchip assembly 62 are substantially identical in size and shape. However, in other embodiments, a configuration of one or more of the microchips 64 may vary. For example, one of the microchips may be smaller in one or more dimensions and/or have a different shape than another of the microchips within the stack.

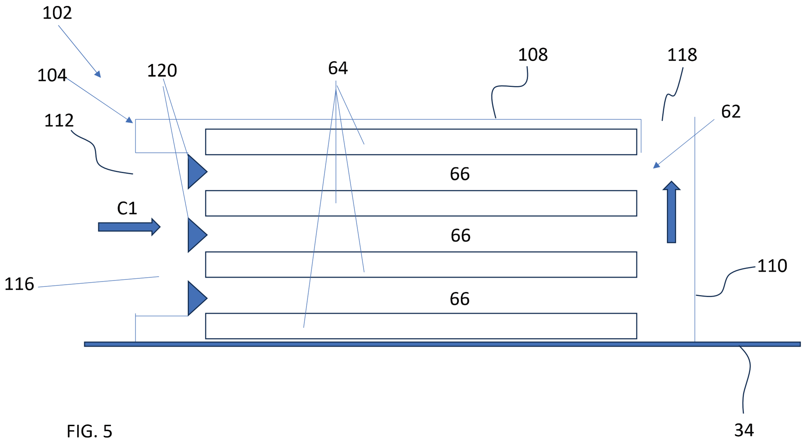

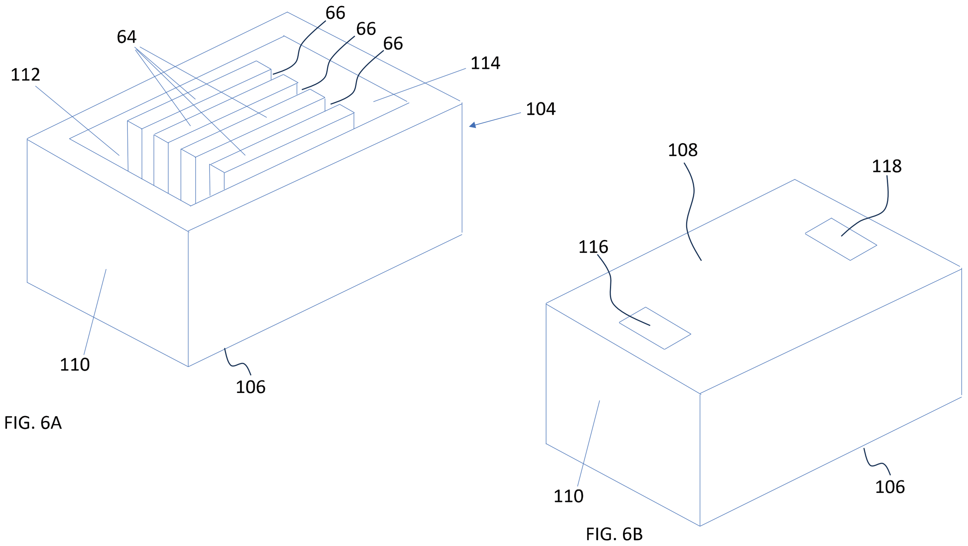

In the illustrated, non-limiting embodiment of FIGS. 4 and 5, the plurality of microchips 64 within the stacked microchip assembly 62 have a generally horizontal orientation and are stacked along a vertical axis. As shown, a first microchip 64 is mounted to the printed circuit board 34 in an orientation generally parallel to the adjacent surface of the printed circuit board 34. In such a configuration, the first microchip 64a defines the footprint of the plurality of microchips within the stack. In the illustrated, non-limiting embodiment, a second microchip 64b is positioned upwardly adjacent to the first microchip 64a and a third microchip 64c is positioned upwardly adjacent to the second microchip 64b. Although a stacked microchip assembly 62 having three microchips is illustrated, it should be understood that a stacked microchip assembly 62 having any suitable number of microchips, such as two microchips, four microchips, or more than four microchips are within the scope of the disclosure. Further, although the microchips 64a-64d in the illustrated stacked microchip assembly 62 are shown as being stacked along a vertical axis, in other embodiments, such as shown in FIG. 6A, the microchips 64 be oriented vertically relative to the printed circuit board 34 and may be stacked along a horizontal axis.

With continued reference to FIGS. 4, 5, 6A and 6B, the server 30 may include a cooling system 100 for removing heat from one or more of the heat-generating electronic devices 50, such as the stacked microchip assembly 62 for example. In embodiments of the server 30 including a stacked microchip assembly 62, the cooling system 100 may include a heat removal device 102 operable to directly cool the stacked microchip assembly 62 using a first cooling fluid C1. Examples of the first cooling fluid C1 include but are not limited to a dielectric fluid, refrigerant, and water. In a stacked microchip assembly 62, adjacent microchips 64 may be mounted or arranged such that a small gap or passageway 66 is defined between a first or upper surface of a microchip and a second or bottom surface of an adjacent microchip. Accordingly, the cooling system 100 may be operable to cool a stacked microchip assembly 62 by passing a first cooling fluid C1 through one or more of the passageways 66 formed between adjacent microchips 64 within the stacked microchip assembly 62.

In the illustrated, non-limiting embodiment, the heat removal device 102 includes a container or structure 104 positioned about the exterior of the stacked microchip assembly 62. As shown, the structure 104 may have a first end 106, a second, opposite end 108, and at least one sidewall 110 extending between and connecting the first end 106 and the second end 108. The first end 106 may be located at or even underneath an end of the stacked microchip assembly 62 positioned closest to the printed circuit board 34 for example. The second end 108 may be positioned adjacent to, and in some embodiments may be vertically offset from, the second opposite end of the stacked microchip assembly 62, such as furthest from the printed circuit board 34. The first end 106, second end 108, and at least one sidewall 110 cooperate to define a substantially hollow interior of the structure 104 within which the entirety or substantial entirety of the stacked microchip assembly 62 is positionable. In an embodiment, the structure 104 arranged about the stacked microchip assembly 62 is hermetically sealed.

An inlet cavity 112 fluidly connected to at least one of the passageways 66 is formed within the interior of the structure 104, such as adjacent to a first lateral side of the plurality of microchips 64. In an embodiment, the inlet cavity 112 is fluidly connected to each of the passageways 66 formed in the stacked microchip assembly 62. An outlet cavity 114 is also fluidly connected to at least one of the passageways 66 formed within the interior of the stacked microchip assembly 62, and in some embodiments to each of the passageways 66. The outlet cavity 114 may be arranged adjacent to a second lateral side of the stacked microchip assembly 62. Although the first lateral side and the second lateral side are illustrated as being directly opposite one another in the FIGS., embodiments where the first lateral side and the second lateral side have another configuration, for example are adjacent to one another, are also contemplated herein. The structure 104 additionally includes an inlet opening 116 arranged in direct fluid communication with the inlet cavity 112 and an outlet opening 118 arranged in direct fluid communication with the outlet cavity 114. In the illustrated, non-limiting embodiment, the inlet opening 116 is formed in the second end 108 of the structure 104 at a position vertically aligned with the inlet cavity 112 and the outlet opening 118 is formed in the second end 108 of the structure 104 at a position vertically aligned with the outlet cavity 118. However, embodiments where the inlet opening 116 and the outlet opening 118 are arranged at another side of the structure 104 and/or at different sides of the structure 104 are also within the scope of the disclosure.

During operation of the cooling system 100, a flow of the first cooling fluid is provided to the inlet cavity via an inlet opening. The first cooling fluid C1 may be in single phase, such as a liquid state for example, when provided to the inlet cavity. From the inlet cavity, the first cooling fluid is provided to one or more of the passageways of the stacked microchip assembly. Within the passageways, the cool first cooling fluid C1 contacts one or more hot surfaces of the adjacent microchips. Heat is absorbed by the first cooling fluid C1, thereby cooling the microchips within the stacked microchip assembly. In some embodiments, the heated first cooling fluid C1 remains a liquid. However, in other embodiments, the first cooling fluid C1 is a two-phase fluid upon reaching the outlet cavity.

In an embodiment, a pressure differential is maintained between the inlet cavity 112 and the outlet cavity 114 to avoid vapor bubbles from becoming trapped within the passageways, also known as "vapor locking." The pressure differential used to drive the flow of the first cooling fluid through the stacked microchip assembly 62 may be achieved passively, such as via the geometry of the passageways. For example, a passageway 66 having a trapezoidal configuration may be operable to facilitate movement of the first cooling fluid through the passageways 66. In such embodiments, the height (measured as the distance between the microchips along the stacking axis) of the passageways 66 may taper, such as from a taller height near the inlet cavity 112 towards a shorter height near the outlet cavity 114. However, any geometry suitable to create a pressure differential that drives the flow of the first cooling fluid C1 through the passageways is contemplated herein. Alternatively, or in addition, the flow of the first cooling fluid C1 may be actively moved through the passageways 66, such as via a pump (not shown). Such a pump may be located upstream or downstream from the passageways 66 and may be located internal to or external to the structure 104.

Alternatively, or in addition, in some embodiments, such as embodiments including vertically oriented microchips for example, one or more surfaces, may be optimized to facilitate boiling of the first cooling fluid C1 within the structure 104. This optimization may include the formation of a specific microstructure at one or more exposed surfaces of the individual chips which may or may not be encased with metallic lids. In an embodiment, this optimization is performed via application a coating or film. Alternatively, this optimization may be performed via a machining process or another suitable manufacturing process. In such embodiments, the first cooling fluid may be a dielectric fluid.

In another embodiment, shown in FIG. 5, the heat removal device 102 includes at least one spray nozzle 120, such as arranged within the inlet cavity 112 for example and associated with one or more of the passageways 66. Although the illustrated non-limiting embodiment includes a plurality of spray nozzles 120 such that an individual spray nozzle is associated with a respective passageway 66, embodiments where a single spray nozzle 120 may be fluidly coupled to multiple passageways 66 are also within the scope of the disclosure. It should be appreciated that although the first cooling fluid C1 is illustrated and described herein as being sprayed in a manner that suitably controls the direction of the spray of first cooling fluid C1, in other embodiments, the first cooling fluid C1 may be dispersed as droplets without any directional control.

Similar to the embodiment of FIG. 4, the first cooling fluid C1 may be a single phase, such as a liquid for example, when expelled from the nozzles 120 into one or more passageways 66 of a stacked microchip assembly 62. The first cooling fluid C1 expelled from the nozzles 120 may be in the form of a fine mist of liquid droplets. As these microdroplets of the cool first cooling fluid C1 contact one or more hot surfaces of at the adjacent microchips 64, heat is absorbed causing the microdroplets to evaporate. The resulting vapor is collected within the outlet cavity 114.

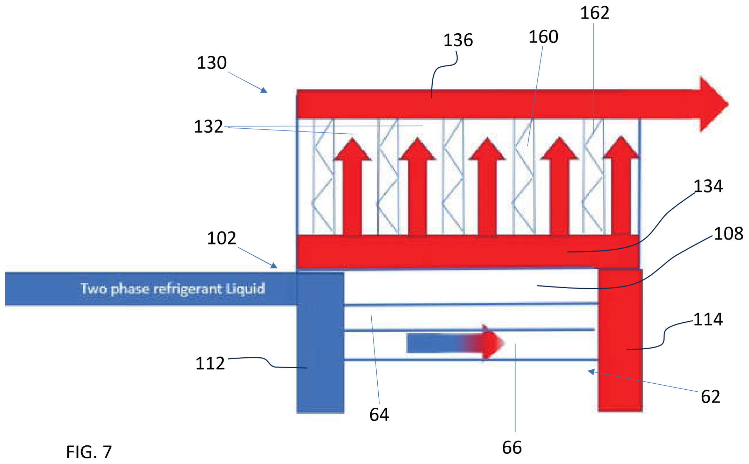

With reference now to FIG. 7, in some embodiments, the cooling system 100 may include one or more additional heat removal devices 130, such as a heat exchanger for example. In an embodiment, the heat removal device 130 is mounted in an axially overlapping relationship with and is thermally coupled to at least one heat-generating electronic device 50. However, the at least one heat removal device 130 may be mounted to any suitable heat-generating device of the server. Accordingly, as shown in FIG. 7, the at least one heat removal device 130 may be thermally coupled to a surface of the structure 104 of the heat removal device 102 associated with the stacked microchip assembly 62, or alternatively, may be thermally coupled to another heat-generating device 50. In embodiments where the heat exchanger 130 is associated with another heat-generating device 50, the another heat generating device may be located at any position about the server 30, including upstream from the stacked microchip assembly 62 or downstream from the stacked microchip assembly 62 relative to a flow of a second cooling fluid C2. Further, embodiments where a heat removal device 130 is mounted at another location of the server 30, remote from the heat-generating electronic devices 50, or alternatively at a location remote from the server 30, are also within the scope of the disclosure.

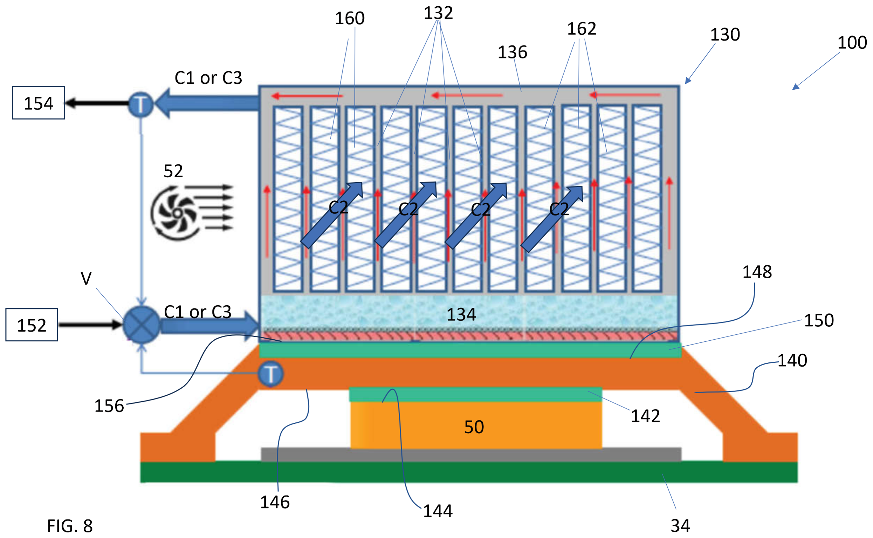

With reference to the cross-sectional view of the heat removal device 130 shown in FIGS. 7 and 8, the heat exchanger 130 may be a microchannel heat exchanger having a plurality of substantially parallel microchannel heat exchanger tubes 132 extending between an inlet header 134 and an outlet header 136, each of the plurality of heat exchanger tubes 132 defining a plurality of fluid flow paths (not shown). However, examples of other types of heat exchangers that may be used, include, but are not limited to, microtube, double pipe, shell and tube, tube and fin, plate, plate and shell, adiabatic shell, plate fin, pillow plate, and fluid heat exchangers. The type of heat exchanger selected may depend at least in part based on the type of fluids being provided thereto.

Two cooling fluids are arranged in a heat transfer relationship at the heat exchanger 130. In an embodiment, the heat exchanger 130 is arranged in series relative to the flow of the first cooling fluid C1. In the illustrated, non-limiting embodiment of FIG. 7, the inlet header 134 is fluidly connected to the outlet cavity 114 of the structure 104 via the opening 118. A second cooling fluid C2 is configured to flow about the exterior of the heat exchanger 130, such as across the plurality of tubes 132 for example. In the non-limiting embodiments illustrated in FIG. 7, the heat exchanger 130 has a single pass configuration for both the first cooling fluid C1 and the second cooling fluid C2. However, in other embodiments, at least one of the first and second cooling fluids C1, C2 may make multiple passes through the heat exchanger 130. Further, the first and second cooling fluids C1, C2 may be arranged in any suitable flow configuration at the heat exchanger, such as a crossflow, a parallel flow, a counter-flow, or any combination thereof.

In other embodiments, such as shown in FIG. 8, the heat exchanger 130 is thermally coupled to a heat generating device 50 that is not a stacked microchip assembly 62. In such embodiments, the heat exchanger 130 may be arranged in series with the heat removal device 102 of a stacked microchip assembly 62 relative to a first cooling fluid C. However, it should be understood that in some embodiments, the heat exchanger is not fluidly connected to the heat removal device 102. For example, the heat exchanger 130 may be configured to receive a third cooling fluid C3, different or distinct from the first cooling fluid C1 and/or the second cooling fluid C2.

When thermally coupled to a heat generating device 50 that is not a stacked microchip assembly 62, the heat exchanger 130 may be directly coupled to a surface of the at least one heat-generating electronic device 50 or may be indirectly coupled thereto. In server applications, the surface area of a heat-generating electronic device available for mounting the heat exchanger 130 may be very small. Because the amount of heat to be dissipated from a heat-generating device 50, such as a central processing unit and/or graphics processing unit, memory, a hard drive, and a power supply module, is typically very high, the surface area available to form an interface with a heat exchanger 130 is insufficient to meet the cooling demand of the heat-generating electronic device 50. Accordingly, in the illustrated, non-limiting embodiment of FIG. 8, a heat spreader 140, such as formed from a conductive material like sheet metal for example, is affixed to the printed circuit board 34 adjacent to a heat-generating electronic device 50. Although the heat spreader 140 is illustrated as axially overlapping both at least one heat-generating electronic device 50 and the printed circuit board 34, embodiments where the heat spreader 140 is arranged at another location relative to the at least one heat-generating electronic device 50 are also contemplated herein.

A thermal interface material 142 may be arranged between a surface 144 of the at least one heat-generating electronic device 50 and an adjacent surface 146 of the heat spreader 140 to facilitate the transfer of heat from the at least one main heat-generating electronic device 64 to the heat spreader 130. The surface area of the surface 146 of the heat spreader facing the at least one main heat-generating electronic device 50 may be greater than, equal to, or in some embodiments, may even be smaller than the surface area of the surface 144 of the at least one heat-generating electronic device 50.

The heat exchanger 130 is thermally coupled to a second, opposite surface 148 of the heat spreader 140. In an embodiment, the second, opposite surface 148 of the heat spreader 140 is greater than the surface of the at least one heat-generating electronic device 50 to facilitate the transfer of heat from the heat spreader 140 to a fluid within the heat exchanger 130, such as the first cooling fluid C1 for example. For example, the surface area of surface 148 of the heat spreader 140 may be at least 30% greater than that of the surface 144 of the at least one heat-generating electronic device 50, and in some embodiments, is at least 40%, 50%, 60%, 70%, 80%, 90%, 100%, or more than 100% greater than the surface 144 of the at least one heat-generating electronic device 50. However, in other embodiments, the surface area of the second surface 148 of the heat spreader 130 may be the same or even smaller than the surface area of the at least one heat-generating electronic device 50. In the illustrated, non-limiting embodiment, the inlet header 134 is positioned directly adjacent to the heat spreader 140 and may be thermally coupled thereto via a thermal interface material 150. The inlet header 134 of the heat exchanger 130 may be fluidly connected to a fluid inlet 152 and the outlet header 136 may be fluidly connected to a fluid outlet 154 to form a flow path of the third cooling fluid C3.

In operation, a cooling fluid, such as the first cooling fluid C1 or a third cooling fluid C3, such as a refrigerant for example, is provided from the fluid inlet 152 into the inlet header 134 of the heat exchanger 130. The first cooling fluid C1 or the third cooling fluid C3 provided to the inlet header 134 may be a single phase, such as a cool or cold liquid for example, or alternatively, may be a two-phase mixture of liquid and vapor. Within the inlet header 134, at least a portion of the heat transferred to the first surface 146 of the heat spreader 140 from the at least one heat-generating electronic device 50 is transferred from the second surface 148 of the heat spreader 140 to the first cooling fluid C1 or the third cooling fluid C3. The heat transferred to the first cooling fluid C1 or the third cooling fluid C3 within the inlet header 134 causes the temperature of the first cooling fluid C1 or the third cooling fluid C3 to increase, and in some embodiments, causes at least a portion of the first cooling fluid C1 or the third cooling fluid C3 within the inlet header 134 to vaporize.

As the first or third cooling fluid C1, C3 vaporizes, the gaseous first or third cooling fluid C1, C3 having some liquid first or third cooling fluid C1, C3 entrained therein flows through the plurality of heat exchange tubes 132 of the heat exchanger 130 toward the outlet header 136. The second cooling fluid C2 is configured to flow through the gaps 160 defined between adjacent heat exchanger tubes 132. In an embodiment, the second cooling fluid C2 is a flow of air moved (in a direction extending into the plane of the page) by the at least one fluid movement device 52 associated with the server 30. However, it should be understood that any fluid, including a liquid such as a dielectric fluid for example, may be used as the second cooling fluid C2.

In the illustrated, non-limiting embodiment, a plurality of fins 162 is arranged within the gaps 160 defined between adjacent heat exchanger tubes; however, embodiments that do not include such fins are also contemplated herein. Within the plurality of passages 160 of the heat exchange tubes 132, heat from the second cooling fluid C2 is transferred to the first or third cooling fluid C1, C3. The resulting cooled second cooling fluid C2 provided at an outlet of the heat exchanger 130 may be configured to flow over another heat-generating electronic devices 50 and remove heat therefrom. Similarly, the now warmer first or third cooling fluid C1, C3 is received from the plurality of heat exchange tubes 132 within the outlet header 136 is provided to the fluid outlet 154.

As best shown in FIG. 8, at least one valve V may be arranged at the first fluid inlet 152 and/or the first fluid outlet 154 to control the flow of the first or third cooling fluid C1, C3 to and from the heat exchanger 130. In an embodiment, the position of the valve(s) V and therefore the flow through the heat exchanger 130, is actively managed based on a thermal load at the heat exchanger 130. The thermal load may be determined on information collected by one or more sensors, represented schematically at T. In the illustrated, non-limiting embodiment, a first sensor is operable to monitor the temperature of the heat spreader 140, and a second sensor is operable to monitor the temperature of the first or third cooling fluid C1, C3 at the outlet header 136. The at least one sensor T may be operable to measure temperature directly or may be configured to monitor another parameter that correlates to or can be used to derive temperature therefrom.

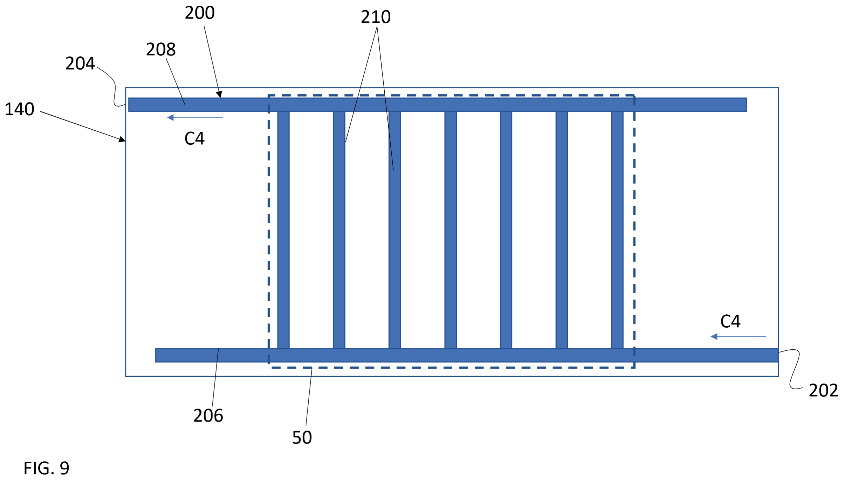

In an embodiment, the heat spreader 140 of the heat removal device 130 is a cold plate having an internal fluid circuit. An example of an internal fluid circuit of the heat spreader 140 is illustrated in the cross-sectional view of the heat spreader shown in FIG. 9. As shown, the fluid circuit 200 includes a fluid inlet 202 and a fluid outlet 204 formed in the body of the heat spreader 140. The fluid inlet 202 and the fluid outlet 204 can be any shape, such as in the depth dimension (e.g., in the z-x plane of the attached figure), including the shape of a circle, oval, triangular, square, rectangular, or any simple polygonal shape or portion thereof. Also, in an embodiment, the fluid outlet 204 can have a much larger diameter compared to the fluid inlet 202, thereby helping to reduce the pressure drop for the cooling medium passing through the fluid outlet 204.

In an embodiment, the fluid circuit includes a single continuous flow path extending between the fluid inlet 202 and the fluid outlet 204. However, in other embodiments, the fluid circuit 200 includes a first or inlet manifold 206, a second or outlet manifold 208, and at least one fluid passage 210 connecting the first and second manifolds 206, 208. In an embodiment, the at least one fluid passage 210 includes a plurality of fluid passages 210. The fluid inlet 202 can be configured to connect a source of a fourth cooling medium C4 to the inlet manifold 206 using any suitable mechanical connection. The fourth cooling medium C4 may be the same as any of the first cooling fluid C1, the second cooling fluid C2, and the third cooling fluid C3, or may be distinct or different therefrom.

In an embodiment, one or more fluid passages 210 of the fluid circuit 200 may be positioned to perform localized cooling at the area of the heat spreader with the greatest heat flux, such as at the area of the heat spreader directly aligned with or in overlapping arrangement with a heat-generating electronic module. Accordingly, the at least one fluid passage 210 may be associated with a heat-generating electronic device 50. In embodiments where the heat spreader is associated with a plurality of heat-generating electronic modules, one or more fluid passages 210 may be associated with and configured to remove heat from a respective heat-generating electronic module. More specifically, the at least one fluid passage 210 associated with a respective heat-generating electronic device 50 may be physically located within the heat spreader 130 in alignment with the heat-generating electronic device 50. Inclusion of a fluid circuit 200 within the heat spreader 130 may reduce the size of the heat removal device 130 of the cooling system 100.

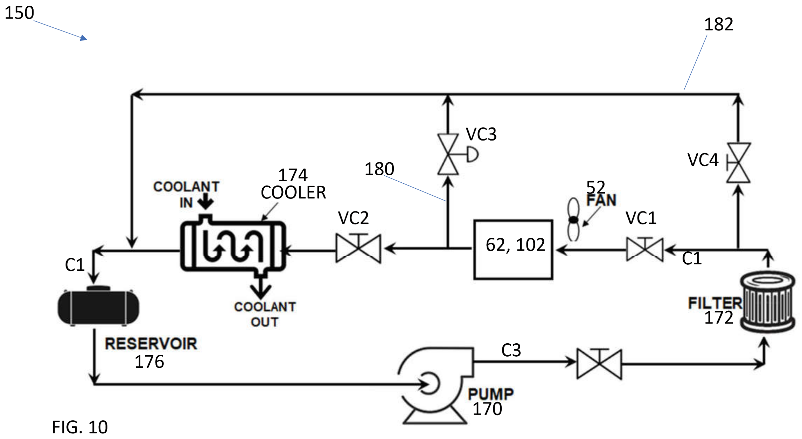

With reference now to FIG. 10, an example of a circuit of the first cooling fluid C1 of the cooling system 100 is illustrated. In the illustrated, non-limiting embodiment, the circuit of the first cooling fluid C1 of the cooling system 100 is a closed loop and includes a pump 170 for moving the first cooling fluid C1 therethrough. A filter 172 may be located upstream from the at least one heat removal device 102 positioned to directly cool a stacked microchip assembly 50. Downstream from the one or more heat removal devices 102 is a cooling heat exchanger 174 configured to remove heat from the first cooling fluid C1. The circuit may additionally include a reservoir or accumulator 176 within which excess first cooling fluid C1 is stored. As shown, the circuit may include a plurality of valves, such as arranged directly upstream from the heat removal device (VC1), directly downstream from a heat removal device (VC2), associated with a bypass conduit 180 for bypassing the cooling heat exchanger (VC3), and associated with another bypass conduit 182 for bypassing both the heat removal device and the cooling heat exchanger (VC4).

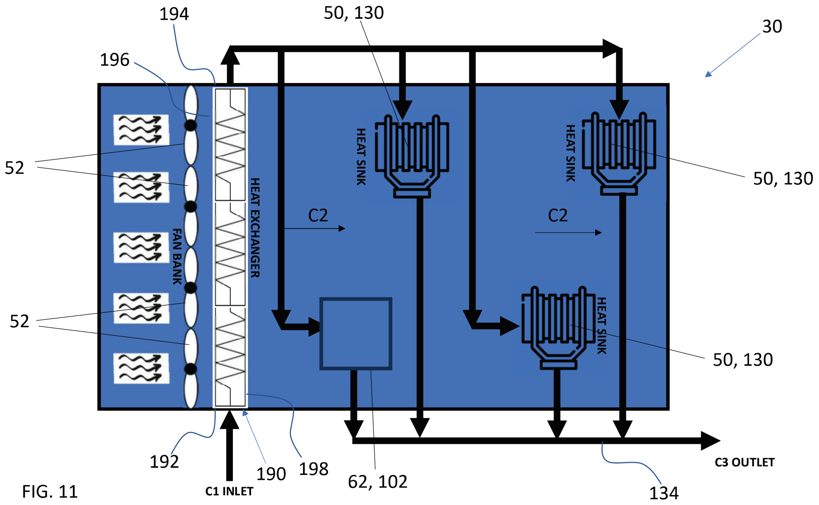

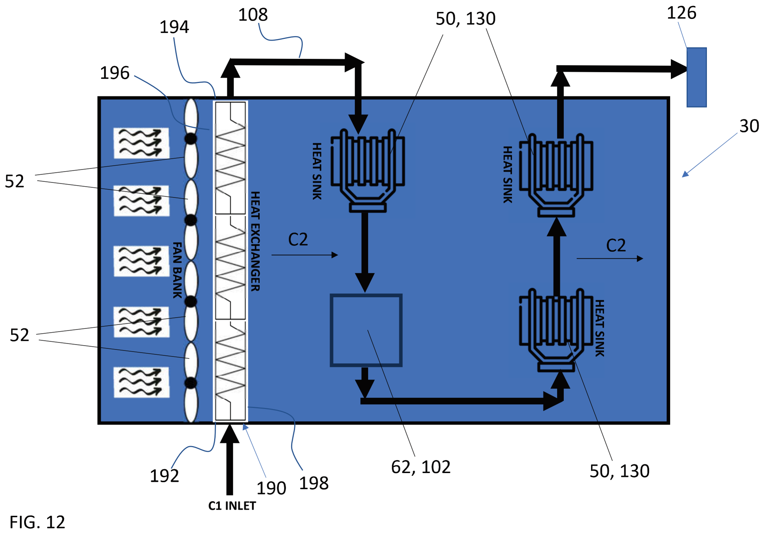

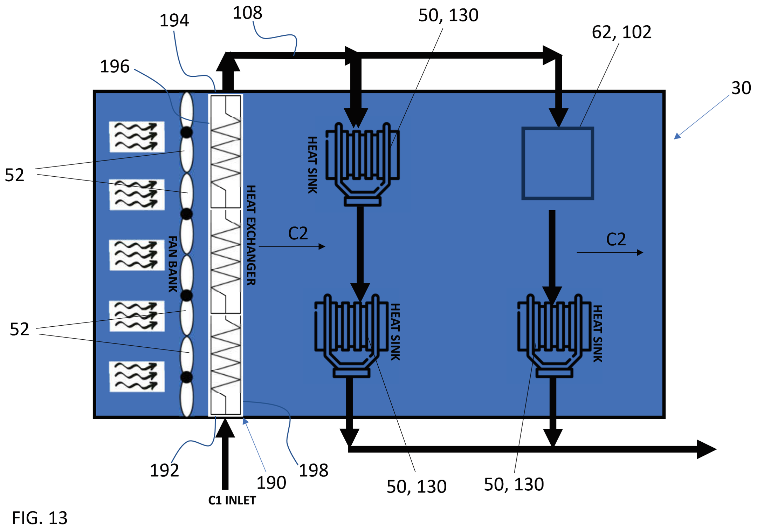

It can be appreciated that in some embodiments, the cooling system 100 may include a plurality of heat removal devices 102, 130, each positioned to directly cool one or more respective heat-generating electronic devices 50, such as a plurality of heat-generating devices including at least one stacked microchip assembly 62 for example. In such embodiments, the first cooling fluid C1 may flow to the plurality of heat removal devices 102, 130 in any suitable manner. For example, each of the plurality of heat removal devices 102, 130 may be fluidly connected in parallel relative to a flow of the first cooling fluid C1 (FIG. 11). In another embodiment, the plurality of heat removal devices 102, 130 may be fluidly connected in series relative to a flow of the first cooling fluid C1 (FIG. 12). In yet another embodiment, the plurality of heat removal devices 102, 130 may be fluidly connected in both parallel and series relative to a flow of the first cooling fluid C1 (FIG. 13).

With continued reference to FIGS. 11-13, the at least one heat removal device 130 may alternatively or additionally include a secondary heat exchanger 190 mounted to the chassis 32 and/or the printed circuit board 34 and located remotely from a heat-generating electronic device 50. In the illustrated, non-limiting embodiments, the secondary heat exchanger 190 is located, upstream from the at least one heat removal device 130 mounted in overlapping arrangement with at least one heat-generating electronic device 50 relative to a flow of the first cooling fluid C1, and in some embodiments relative to a flow of the second cooling fluid C2. For example, the secondary heat exchanger 190 may be mounted near a first end 54 of the printed circuit board 34, at a location between the at least one heat-generating electronic device 50 and the at least one fan 52. However, embodiments where the secondary heat exchanger 190 is arranged at another location are also contemplated herein.

The secondary heat exchanger 190 may be any suitable type of heat exchanger. In an embodiment, the secondary heat exchanger 190 is a microchannel heat exchanger having a plurality of substantially parallel microchannel heat exchanger tubes, each defining a plurality of fluid flow paths (not shown). However, examples of other types of heat exchangers that may be used, include, but are not limited to, microtube, double pipe, shell and tube, tube and fin, plate, plate and shell, adiabatic shell, plate fin, pillow plate, and fluid heat exchangers.

In the illustrated, non-limiting embodiments, the secondary heat exchanger 190 has an inlet 192 and an outlet 194 defining a flow path for the third cooling fluid C3 and another inlet 196 and another outlet 198 defining a flow path for the second cooling fluid C2. The first cooling fluid C1 and the second cooling fluid C2 may each make a single pass through the secondary heat exchanger 190. However, in other embodiments, at least one of the first cooling fluid C1 and the second cooling fluid C2 may make multiple passes through the secondary heat exchanger 190. Further, the first cooling fluid C1 and the second fluid C2 may be arranged in any suitable flow configuration at the heat exchanger, such as a crossflow, a parallel flow, a counter-flow, or any combination thereof.

In an embodiment, the secondary heat exchanger 190 is configured as a cooling coil and the first cooling fluid C1 provided to secondary heat exchanger 190 is configured to absorb heat from the second cooling fluid C2. During operation, the at least one fan 52 provides a flow of the second cooling fluid C2, such as ambient air for example, to the secondary heat exchanger 190. Within the secondary heat exchanger 190, the cool or cold first cooling fluid C1 absorbs heat from the second cooling fluid C2. The first cooling fluid C1 at both the inlet 192 and the outlet 194 may be a single phase, such as a liquid for example, such that the first cooling fluid C1 provided to a downstream heat removal device 102, or 130 is a single phase and is at a temperature capable of absorbing heat from one or more selected heat-generating electronic devices 50. It should be appreciated that the second cooling fluid C2 output from the outlet 198 of the secondary heat exchanger 190 may have passed over and therefore absorbed heat from one or more heat-generating electronic devices 50 prior to reaching a heat removal device 130.

In embodiments of the cooling system 100 that include a secondary heat exchanger 190 mounted upstream from the plurality of heat-generating electronic devices 50, cooling of the second cooling fluid C2 need not be performed at the downstream heat removal devices 130. Accordingly, any heat removal devices 130 mounted in overlapping arrangement with a heat-generating electronic device 50 need not be heat exchangers. In such embodiments, the cooling of the selected heat-generating electronic devices 50 may be performed primarily by the flow of the first cooling fluid C1 through a respective heat removal device 102, 130.

A cooling system 100 as illustrated and described herein provides a means for individually cooling the plurality of microchips within a stacked microchip assembly 62. Further, the cooling system 100 is an easily scalable solution for cooling heat-generating components. Such a cooling solution can improve the sustainability and efficiency of the heat-generating components by rejecting the heat absorbed from the heat-generating component to a downstream heating application. In addition, the air conditioning load for cooling an area containing a data center is reduced.

The term "about" is intended to include the degree of error associated with measurement of the particular quantity based upon the equipment available at the time of filing the application.

The terminology used herein is for the purpose of describing particular embodiments only and is not intended to be limiting of the present disclosure. As used herein, the singular forms "a," "an" and "the" are intended to include the plural forms as well, unless the context clearly indicates otherwise. It will be further understood that the terms "comprises" and/or "comprising," when used in this specification, specify the presence of stated features, integers, steps, operations, elements, and/or components, but do not preclude the presence or addition of one or more other features, integers, steps, operations, element components, and/or groups thereof.

While the present disclosure has been described with reference to an exemplary embodiment or embodiments, it will be understood by those skilled in the art that various changes may be made and equivalents may be substituted for elements thereof without departing from the scope of the present disclosure. In addition, many modifications may be made to adapt a particular situation or material to the teachings of the present disclosure without departing from the essential scope thereof. Therefore, it is intended that the present disclosure not be limited to the particular embodiment disclosed as the best mode contemplated for carrying out this present disclosure, but that the present disclosure will include all embodiments falling within the scope of the claims.

## Claims

1. A cooling system (100) comprising:
a heat removal device (102) operable to cool a first heat-generating device (50), the first heat-generating device being a stacked microchip assembly (62), the heat removal device including:
a structure (104) having a first end (106), a second end (108), at least one sidewall (110) extending between and connecting the first end and the second end, and a hollow interior, the stacked microchip assembly being positionable within the hollow interior;
an inlet cavity (112) arranged within the hollow interior, the inlet cavity being fluidly connectable to at least one passageway (66) formed in the stacked microchip assembly;
an inlet opening (116) formed in the structure, the inlet opening being fluidly connected with the inlet cavity;
an outlet cavity (114) arranged within the hollow interior, the outlet cavity being fluidly connectable to at least one passageway (66) formed in the stacked microchip assembly;
an outlet opening (118) formed in the structure, the outlet opening being fluidly connected with the outlet cavity; and
a first cooling fluid (C1) circulatable through the heat removal device, the first cooling fluid being movable from the inlet cavity to the outlet cavity through the at least one passageway formed in the stacked microchip assembly.

2. The cooling system of claim 1, wherein the structure is hermetically sealable about the stacked microchip assembly.

3. The cooling system of claim 1 or claim 2, wherein the first cooling fluid is operable to passively circulate through the cooling system, or wheein the cooling system comprises a pump (170) fluidly connectable to at least one of the inlet cavity and the outlet cavity, the pump being operable to actively circulate the first cooling fluid through the cooling system.

4. The cooling system of any of the preceding claims, further comprising at least one spray nozzle (120) arranged within the inlet cavity, the at least one spray nozzle being oriented to spray the first cooling fluid into the at least one passageway formed in the stacked microchip assembly.

5. The cooling system of any of the preceding claims, wherein the first end of the structure is positionable adjacent to a printed circuit board (34) coupled to the stacked microchip assembly and at least one of the inlet opening and the outlet opening is formed in the second end of the structure.

6. The cooling system of any of the preceding claims, wherein the first cooling fluid provided to the inlet cavity is a single phase, optionally wherein the first cooling fluid provided to the inlet cavity is a liquid.

7. The cooling system of any of the preceding claims, further comprising:
a second heat removal device (130), the second heat removal device being arranged in series with the heat removal device relative to a flow of the first cooling fluid.

8. The cooling system of claim 7, wherein the second heat removal device is arranged downstream from the heat removal device relative to a flow of the first cooling fluid, optionally wherein the second heat removal device is a heat exchanger.

9. The cooling system of claim 7 or 8, wherein the second heat removal device is thermally coupled to a surface of the heat removal device, and/or wherein the second heat removal device is thermally coupled to a surface of a second heat-generating device (50), the second heat-generating device being distinct from the first heat-generating device.

10. The cooling system of claim 7 or 8, further comprising:
at least one fluid movement device (52) for providing a second cooling fluid (C2) to the second heat removal device, the second cooling fluid being arranged in a heat transfer relationship with the first cooling fluid at the second heat removal device.

11. A method of cooling a stacked microchip assembly (64), the method comprising:
providing a heat removal device (102) including a structure (104) having a hollow interior within which the stacked microchip assembly is arranged; and
moving a first cooling fluid (C1) through one or more passageways (66) formed in the stacked microchip assembly.

12. The method of claim 11, wherein moving the first cooling fluid through the one or more passageways includes passively moving the first cooling fluid through the one or more passageways, optionally wherein passively moving the first cooling fluid includes maintaining a pressure differential between an inlet cavity (112) and an outlet cavity (114) fluidly coupled to opposite ends of the one or more passageways.

13. The method of claim 11, wherein moving the first cooling fluid through the one or more passageways includes pumping the first cooling fluid through the one or more passageways.

14. The method of any of claims 11 to 13, wherein the first cooling fluid provided to the one or more passageways formed in the stacked microchip assembly is a liquid.

15. The method of any of claims 11 to 14, further comprising arranging the first cooling fluid in a heat transfer relationship with a second cooling fluid (C2) at a second heat removal device (130), the second heat removal device being arranged in series with the heat removal device.
